# EUROPÄISCHE PATENTSCHRIFT

(11) **EP 0 818 889 B1**
(45) Veröffentlichungstag und Bekanntmachung des Hinweises auf die Patenterteilung: **22.10.2003**
(21) Anmeldenummer: 97111420.2
(22) Anmeldetag: 07.07.1997
(51) Int. Cl.: H03K 17/0812, H03K 17/12

(54) **Gatespannungsbegrenzung für eine Schaltungsanordnung**
Gate voltage limiting for a circuit arrangement
Limitation de la tension de grille pour un montage

(30) Priorität: 12.07.1996 DE 19628131
(43) Veröffentlichungstag der Anmeldung: 14.01.1998
(73) Patentinhaber: SEMIKRON Elektronik GmbH, 90431 Nürnberg (DE)
(72) Erfinder: Mourick, Paul, Dr., 90766 Fürth (DE); Schreiber, Dejan, 90513 Zirndorf (DE); Anderlohr, Erik, 90513 Zirndorf (DE)

(56) Entgegenhaltungen:
- EP-A- 0 427 143
- EP-A- 0 581 016
- EP-A- 0 664 613

## Beschreibung

Die Erfindung beschreibt eine Schaltungsanordnung der Leistungsklasse nach den Merkmalen des Oberbegriffes des Anspruches 1. Solche Schaltungen sind mehrfach aus der Literatur durch Beschreibung ihrer Anordnungen bekannt. Die Erhöhung der Leistungsdichte und der immer weiter greifende hybride Aufbau von Schaltungsanordnungen der Leistungsklasse erbringt und erzwingt immer weitergehende Problemlösungen, um parasitäre Einflüsse zu dämpfen, zu reduzieren oder gar zu eliminieren und damit die Zuverlässigkeit der Schaltungen zu erhöhen. Insbesondere wird in verstärktem Maße versucht, verbesserte Schaltungsvarianten zur Erhöhung der Kurzschlußfestigkeit zu finden.

In DE 41 05 155 wird eine Optimierung der Kommutierungskreise einer Stromrichter-Schaltungsanordnung der Leistungsklasse vorgestellt. Diese Erfindung ist dadurch gekennzeichnet, daß das schaltbare Bauelement des entsprechenden Kommutierungskreises eng benachbart zu dem schaltenden Halbleiterbauelement angeordnet ist. Dadurch werden parasitäre Induktivitäten zumindest reduziert. Das Minimieren der parasitären Induktivitäten reduziert die Überspannungen im Schaltprozeß und ermöglicht so eine bessere Belastbarkeit der Schaltungsanordnung.

In DE 42 40 501 wird eine Leistungshalbleiterschaltungsanordnung vorgestellt, deren positive und negative Stromzuführungen geteilt werden, um deren Induktivitäten zu reduzieren. Die Erkenntnisse einer bestimmten Symmetrie der Schaltungsanordnung im Gleichstromzweig werden weiter ausgebaut. Der Gewinn an Leistungsdichte in den Schaltungsanordnungen wird bei Erhöhung der Packungsdichte in immer stärkeren Maße von der Ansteuerung in allen Schaltungselementen beeinflußt.

Bei eng gestapelten Hauptstrom- und Ansteuerverbindungen in Schaltungsanordnungen hoher Packungsdichte, insbesondere bei Leistungsschaltern mit hoher Schaltgeschwindigkeit und großen Werten von ^{di}/_{dt} (schnelle Schalter) beeinflußt das Magnetfeld der Hauptstromführungen, das jede einzelne Leistungsschiene bei Betrieb aufbaut, jeden in unmittelbarer Nähe liegenden Ansteuerkreis. Hier können Rückwirkungen und gegenseitige Beeinflussungen auftreten, was bereits in EP 0 427 143 B1 erwähnt wird, ohne daß hier die physikalischen Vorgänge der transformatorischen Einkopplung beschrieben werden. Eine eigene frühere Anmeldung (P195 38 328.1-32) hatte sich die Aufgabe gestellt, eine rückwirkungsfreie Ansteuerung von Leistungshalbleiterbauelementen ohne Transformatoreffekt in Leistungsschaltungen durch magnetische Entkoppelung von Ansteuerkreis und Hauptstromkreis vorzustellen. Die Aufgabe wird dort durch genaue Vorschriften für die geometrische Anordnung der elektrischen Zuleitungen für den Ansteuerkreis gelöst.

DE 44 10 978 A1 beschreibt ein Verfahren und eine dazugehörige Schaltung zur Verbesserung der Kurzschlußfestigkeit eines bipolaren IGBT. Diese Erfindung ist dadurch gekennzeichnet, daß die Schaltung einen MOS- Transistor zur Verringerung der an der Gate- Elektrode des IGBT angelegten Spannung während eines Kurzschlußzustandes derart aufweist, daß der Kurzschlußstrom, der durch den IGBT fließt, verringert wird. Die in dieser Schaltungsanordnung zur Realisierung der Gate- Spannungsfestigkeit eingesetzten ZenerDioden begrenzen die Spannung zwischen dem MOSFET und der Gate- Elektrode des IGBT. Aus einer Studienarbeit "Weiterentwicklung und Erprobung einer zweistufigen Ansteuerschaltung für IGBT", P. Nagengast, Universität Erlangen, Lehrstuhl für elektrische Antriebe vom 12.11.1992, ist eine solche kurzschlußgesicherte Treiberschaltung bekannt, die mit einem geringen Bauelementeaufwand arbeitet.

Mit DE 43 20 021 A1 und US 4 719 531 sind zwei Schaltungsanordnungen bekannt, die U_{CE}-Überwachungen von Einzelschaltern in Schaltungsanordnungen beschreiben. Ein beschränkter Kurzschlußschutz kann mit solchen Schaltungsanordnungen erreicht werden, für parallel geschaltete Leistungsschalter sind solche Kurzschluß- Überwachungen ungeeignet. Durch die Temperaturabhängigkeit der U_{CE}- Überwachung wird die Abschaltüberspannung in nicht erwünschter Weise erhöht.

Im Rahmen des 24. Kolloquiums für Halbleiter- Leistungsbauelemente, 13.11.95 in Freiburg, wurde von S. Konrad ein "Schutzkonzept für spannungsgesteuerte Leistungshalbleiter" vorgestellt. Hier wird die Gate- Emitter- Spannung eines IGBT- Schalters durch den Einbau eines MOSFET auf einen bestimmten Wert begrenzt.

Die vorliegende Erfindung hat sich die Aufgabe gestellt, eine einfache Gate- Ansteuerung von Schalterbauelementen bei deren Anwendung in parallelgeschalteten Halbbrücken unter Berücksichtigung einer Gate- Spannungsbegrenzung zur Erreichung der Kurzschlußbeständigkeit vorzustellen. Die Aufgabe wird bei Brückenschaltungen der dargestellten Art durch die Maßnahmen des kennzeichnenden Teiles des Anspruches 1. gelöst, bevorzugte Weiterbildungen werden in den Unteransprüchen gekennzeichnet.

Jede Schaltungsanordnung besteht aus Ansteuerungs- und Hauptstromkreisen. Beide Arten von Stromkreisen sind an den Stellen der Schalter (Grundlage sind hier beispielhaft IGBT oder MOSFET) räumlich am dichtesten gepackt. Die räumliche Gestaltung dieser Engpunkte ist bei hoher Packungsdichte von ausschlaggebender Bedeutung für die Leistungsfähigkeit der gesamten Schaltungsanordnung, da die Beeinflussung des Ansteuerkreises durch den Hauptstromkreis minimiert werden muß. Zur Lösung der hierdurch bedingten Probleme trägt die vorliegende Erfindung bei.

Bei den modernen Hochleistungs- Schalttransistoren beträgt die Leistungsaufnahme der Ansteuerung nur einen äußerst geringen Bruchteil der Leistungen, die im entsprechenden Hauptstromkreis geschaltet werden und die Schaltfrequenzen wie auch die Schaltgeschwindigkeiten nehmen bei Neukonstruktionen weiter zu.

Auf der Grundlage der nachfolgenden Erläuterungen von Ausschnitten beispielhaft ausgewählter Schaltungsanordnung wird die erfinderische Gate- Ansteuerung anhand der Figuren 1 bis 8 näher erklärt.
- **Fig. 1**: zeigt einen Ausschnitt einer Schaltungsanordnung mit einem Einzelschalter nach dem Stand der Technik ohne Begrenzungselemente für die Gate- Ansteuerung.
- **Fig. 2**: stellt den Ausschnitt der TOP- Ansteuerung analog Fig. 1 bei drei parallel geschalteten Leistungsschaltern dar. In dem Detail Fig. 2a und 2b wird das Verhalten einer unsymmetrisch angesteuerten Halbbrücke erläutert.
- **Fig. 3**: skizziert einen Ausschnitt einer vergleichbaren Anordnung mit Transistoreinsatz.
- **Fig. 4**: skizziert eine Gate- Spannungsbegrenzung mittels einer Schottky- Diode für eine Halbbrücke ohne Parallelschaltung
- **Fig. 5**: zeigt eine Gate- Spannungsbegrenzung mittels Schottky- Dioden und Kondensatoren.
- **Fig. 6**: stellt eine Gate- Ansteuerung für parallelgeschaltete Halbbrücken analog Fig. 5 dar.
- **Fig. 7**: stellt eine weitere Schaltungsanordnung mit einer Referenzdiode dar.
- **Fig. 8**: zeigt einen Schaltungsausschnitt mit Hilfsemitter- Widerständen und Schottky- Dioden.

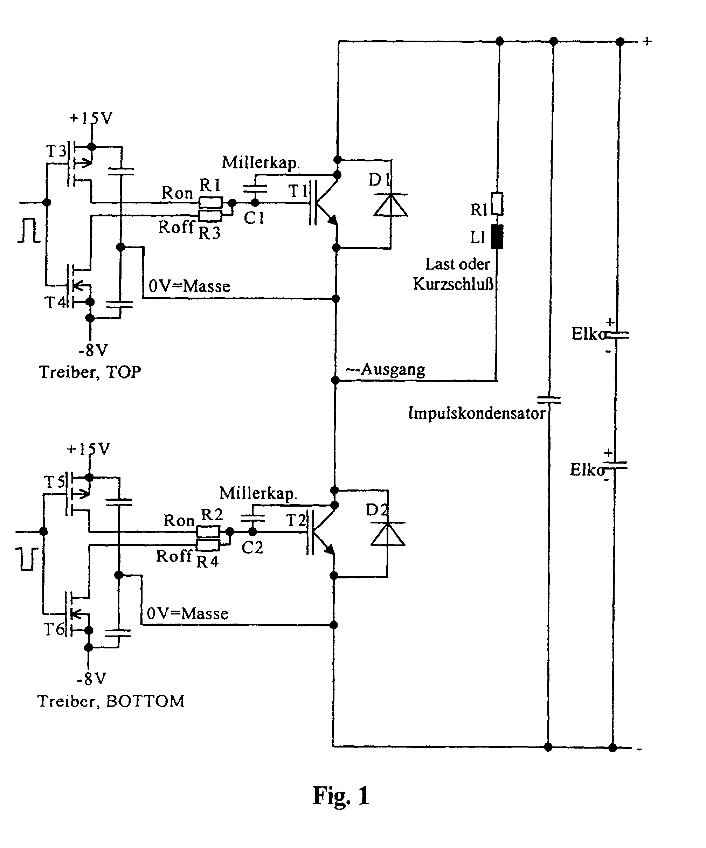

**Fig. 1** zeigt einen Ausschnitt einer Schaltungsanordnung mit einem Einzelschalter nach dem Stand der Technik ohne Begrenzungselemente für die Gate- Ansteuerung. Es wird eine übliche Halbbrückenschaltung mit den IGBT T₁ und T₂ dargestellt. Von den dazugehörigen Treiberschaltungen sind jeweils nur die Endstufen T₃/T₄ der TOP- Ansteuerung bzw. T₅/T₆ der BOTTOM- Ansteuerung mit der dazugehörigen Ausgangsschaltung dargestellt. Zur Verdeutlichung sind die sogenannten Miller- Kapazitäten C₁ und C₂ als externe Kapazitäten gezeichnet, obwohl sie, dem Stand der Technik entsprechend, in der Struktur des IGBT-Schalters integriert sind.

Der IGBT T₁ bzw. T₂ wird eingeschaltet, indem das jeweilige Gate über den oberen MOSFET T₃ bzw. T₅ der jeweiligen Treiberendstufe und dem Gate- Widerstand R₁ bzw. R₂ auf +15V der Treiber- Betriebsspannungsquelle aufgeladen wird, während der in Reihe geschaltete MOSFET T₄ bzw. T₆ sperrt.

Der IGBT T₁ bzw. T₂ wird ausgeschaltet, indem der MOSFET T₃ bzw. T₅ gesperrt werden und über den entsprechenden in Reihe geschalteten MOSFET T₄ bzw. T₆ und die Widerstände R₁ und R₃ bzw. R₂ und R₄ das Gate auf-8 V entladen wird. Das Ein- und Ausschalten wird hier wie bei jedem MOS- gesteuerten Schalter durch das Laden und Entladen der Gate-Emitterkapazität bewirkt, wobei wegen des Spannungshubes zwischen Kollektor und Emitter immer auch die Miller- Kapazität C₁ bzw. C₂ des IGBT T₁ bzw. T₂ mit umgeladen werden muß.

Entsteht nun im Stromkreis des leitenden IGBT ein Kurzschluß, so stellt dieser IGBT das wesentliche, strombegrenzende Element in diesem Stromkreis dar. Die Amplitude des Kurzschlußstromes wird durch die endliche Verstärkung und der in dem Moment anstehenden Gate- Emitter- Spannung des IGBT bestimmt. Der wegen des ansteigenden Kurzschlußstromes stark positive Spannungshub ^{dU}_{^{CE}/_{dt}} an der Kollektor- Emitter- Strecke des IGBT T₁ bzw. T₂ bewirkt eine Umladung der Miller- Kapazität C₁ bzw. C₂ .

Der Umlade- Stromimpuls durch die Miller- Kapazität C₁ bzw. C₂ erhöht jedoch die Gate-Emitter- Spannung des IGBT T₁ bzw. T₂, da sein Gate durch den Widerstand R₁ bzw. R₂ gegenüber der Treiberendstufe entkoppelt ist, so daß der Kurzschlußstrom noch weiter ansteigen kann. Dies kann zu Kurzschluß- Stromimpulsen führen, deren Amplitude weit über der durch die Treiberspannung von +15 V vorgegebenen Gate- Emitter- Spannung liegen kann.

Die Gefahr eines dadurch bedingten Ausfalles des Schalters IGBT ist um so größer, je ungünstiger sein Verhältnis zwischen Gate- Emitter- Kapazität und Miller- Kapazität ist. Nach dem Stand der Technik werden zur Gate- Spannungsbegrenzung Suppressordioden eingesetzt, wie sie beispielhaft aus der genannten Studienarbeit "Weiterentwicklung bei IGBT" bekannt sind.

Nachteilig wirkt sich in dieser Schaltung die Temperaturabhängigkeit und die Toleranz der Suppressordioden aus. Bei modernen IGBT- Schaltern neuester Generation kann mit einer solchen Schaltungsanordnung nicht mehr eine ausreichende Kurzschlußfestigkeit erreicht werden.

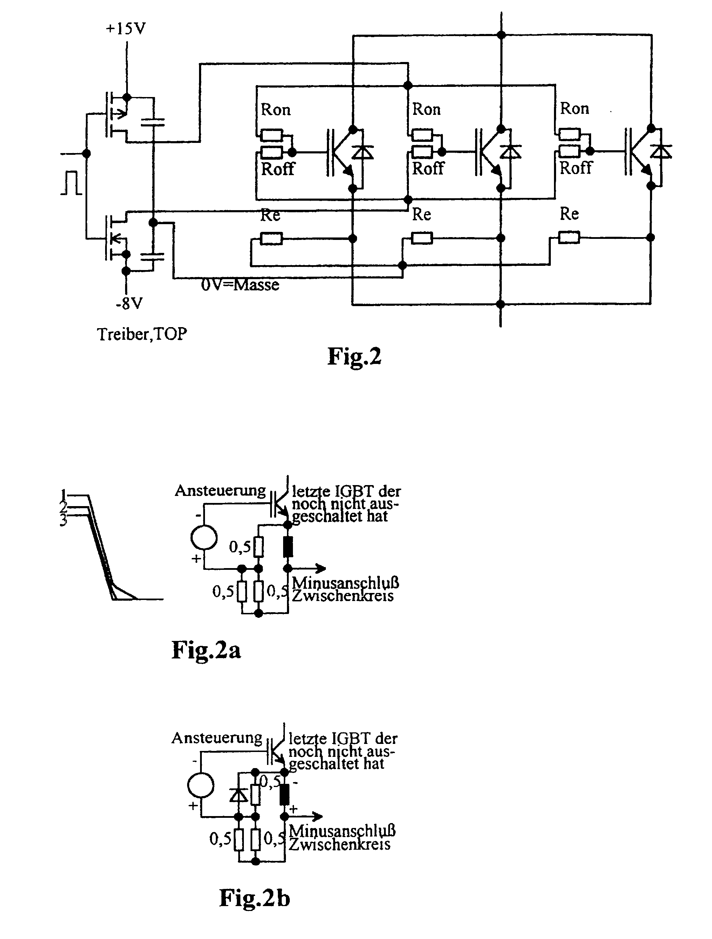

**Fig. 2** stellt den Ausschnitt der TOP- Ansteuerung analog Fig. 1 bei drei parallelgeschalteten Leistungsschaltern dar. Wie aus dem Schaltbild erkennbar ist, werden sowohl die Hauptemitter als auch die Hilfsemitter parallelgeschaltet. Wenn auf die Parallelschaltung der Hilfsemitter verzichtet wird und nur ein Hilfsemitteranschluß vorgesehen wird, können Schwingungen in den Leistungsschaltern, insbesondere im Kurzschlußfall, auftreten. Das Gate ist dann über die Ansteuerschaltung nicht mehr bei jedem Modul dem eigenen Emitter zugeordnet. Durch die Parallelschaltung der Hilfsemitter wird diese Zuordnungsproblematik umgangen.

Allerdings sind jetzt Kreisströme über den Kreis: Hilfsemitter - Hauptemitter möglich. Um diese Kreisströme in ihren Amplituden zu begrenzen, werden Hilfsemitter- Widerstände (Re) von vorzugsweise je 0,5 Ohm eingesetzt. Die Spannungsreferenz für die Ansteuerschaltung ist dann die mittlere Emitterspannung. Durch die Kreisströme über diese Widerstände können allerdings wiederum Gate- Spannungsbeeinflussungen auftreten. Dies tritt insbesondere bei Unsymmetrien in der Strombelastung der Module auf.

Wenn, wie hier beispielhaft gezeigt wird, bereits zwei Module während eines Kommutierungsvorganges den Strom ausgeschaltet haben und nur noch ein Modul den Strom führt, dann tritt die Situation von **Fig. 2a & b** ein: Im linken Teil der Fig. 2a sind die drei Modulströme während des Abschaltvorganges dargestellt. Diese zeigen, daß das di/dt des Stromes 1 wesentlich niedriger wird, nachdem die Ströme 2 und 3 bereits zu Null geworden sind. Es tritt dabei die im mittleren Kurvenverlauf dargestellte Situation ein. Die Induktivitäten zum Minusanschluß des Zwischenkreises sind für die Ströme 2 und 3 nicht mehr wirksam weil dort keine großen Ströme fließen, sie können somit im Ersatzschaltbild vernachlässigt werden. Die Induktivität 1 ist immer noch wirksam.

Diese Induktivität, die normalerweise außerhalb des Gate- Ansteuerkreises liegt, wird jetzt plötzlich wirksam und zwar durch die Konfiguration der Hilfsemitter- Widerstände, in diesem Beispiel mit ²/₃ seines Wertes. Die Emittergegenkopplung des langsamsten IGBT wird dadurch noch einmal verstärkt und der IGBT- Schalttransistor wird noch langsamer. Diese Effekte können in Prinzip bei jedem Modul in einer Halbbrücke mit Parallelschaltung auftreten.

Eine wesentliche Reduzierung dieses Effektes ist dadurch möglich, daß der Ohmsche Spannungsteiler der Hilfsemitter- Widerstände während der Abschaltphase nicht wirksam wird. Am einfachsten ist dies durch Dioden parallel zu den Hilfsemitter- Widerständen zu erreichen. Hierbei ist zu berücksichtigen, daß die Spannung an der verbleibenden Induktivität an der Seite zum Zwischenkreis hin während des Abschaltvorganges positiv ist. Damit also die Diode wirksam ist, muß ihre Kathode, wie in Fig. 2b gezeichnet, mit dem Emitter des IGBT verbunden werden. Hiermit ist dann der starke Einfluß der Induktivität außerhalb des Gate- Ansteuerkreises eliminiert. Diese Dioden müssen bei jedem IGBT vorgesehen werden, damit alle möglichen Stromunsymmetrien durch diese Maßnahme erfaßt werden. Vorzugsweise werden für die Dioden Schottky- Dioden verwendet, weil diese geringere Durchlaßspannungen aufweisen.

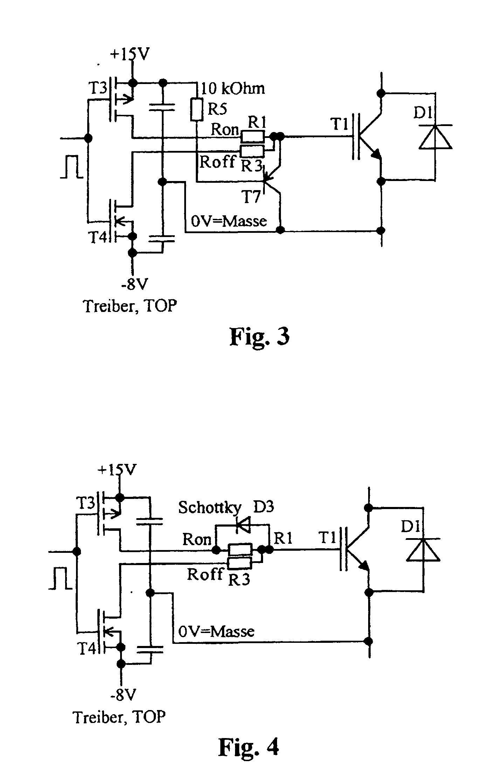

**Fig. 3** skizziert einen Ausschnitt einer vergleichbaren Anordnung mit Transistoreinsatz, sie stellt eine zweite Möglichkeit der Gate- Spannungsbegrenzung nach dem Stand der Technik dar, wie sie bereits 1993 in genannter Studienarbeit publiziert wurde. Tritt in einem Kurzschlußfall die Gate- Emitter- Spannung von T₁ wegen der Wirkung der Miller-Kapazitäten über den Sollwert der Treiber- Betriebsspannung von +15 V plus dem Wert der Basis- Emitter- Stecke der pnp- Transistoren T₇, dann steuert der Transistor T₇ durch und übernimmt den Umladestromimpuls der Miller- Kapazität. Die Gate- Emitterspannung von T₁ wird somit begrenzt.

Diese Lösung kann folglich nicht bei einer Parallelschaltung von IGBT eingesetzt werden, weil die Betriebsspannung als Spannungsreferenz nicht mehr eindeutig den Emittern jedes einzelnen IGBT zuordenbar ist, sondern sich auf den Mittelwert aller Emitterpotentiale bezieht. Für parallelgeschaltete IGBT müssen andere Lösungsvarianten gefunden werden.

**Fig. 4** skizziert eine Gate- Spannungsbegrenzung beispielhaft mittels einer Schottky- Diode (D3) für eine Halbbrücke ohne Parallelschaltung. Dargestellt ist eine Begrenzungsschaltung mit nur einem zusätzlichen Bauteil pro IGBT- Schalter. Eine schnelle Diode D₃ überbrückt hier bei einem Kurzschluß im eingeschalteten Zustand den Widerstand R₁ und leitet den Umladestromimpuls der entsprechenden Miller- Kapazität über die im MOSFET T₃ integrierte antiparallele Diode zur Treiber- Versorgungsspannungsquelle ab.

Die Wirksamkeit dieser Schaltung wird jedoch durch die parasitären Induktivitäten der Verbindungsleitungen zwischen Treiberendstufe und den Gate- und Emitter- Anschlüssen des IBGT nachteilig beeinflußt. Ein Nachteil, der nicht in allen Aufbauvarianten von Schaltungsanordnungen auftritt. Die in Reihe geschalteten Dioden, D₃ und die im Transistor T₃ integrierte, wirken als Begrenzungsdioden.

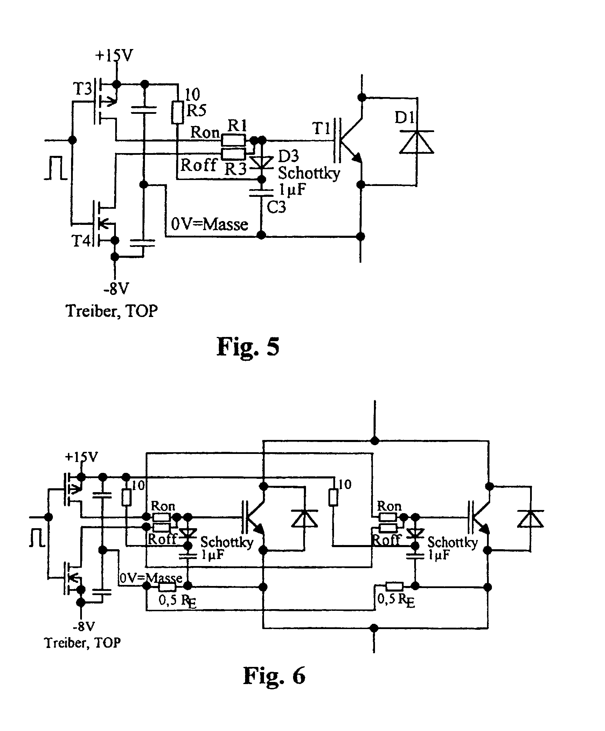

**Fig. 5** zeigt als Stand der Technik eine Gate- Emitter- Spannungsbegrenzung mit Hilfe einer zusätzlichen Schottky- Diode D₃ und einem Kondensator C₃ in unmittelbarer Nähe der Gate-Emitter- Anschlüsse der IGBT T₁. Dargestellt ist hier wiederum die Skizze eines Schaltungsausschnittes der Treiberentstufe der TOP- Ansteuerung.

Der Kondensator C₃ wird über den Widerstand R₅ (mit einem typischen Wert von ca. 10 Ohm) auf die Ursprungsspannung des Treibers von + 15 V aufgeladen. Eine ausreichende Gate-Emitter- Spannungsbegrenzung wird erreicht, wenn die Kapazität C₃ deutlich größer als die Gate- Emitter- Kapazität des betreffenden IGBT ist. Der Kondensator C₃ kann dann nämlich im Kurzschlußfall den Umlade- Stromimpuls durch die Miller- Kapazität ohne nennenswerten Spannungsanstieg aufnehmen.

**Fig. 6** stellt eine Gate- Ansteuerung für parallelgeschaltete Halbbrücken analog Fig. 5 dar. Diese Schaltung ist jedoch für eine Parallelschaltung weniger gut geeignet, weil die Emitterinduktivitäten insbesondere bei unsymmetrischer Stromaufteilungen mit den Kondensatoren Wechselwirkungen in Form von Schwingungen verursachen können.

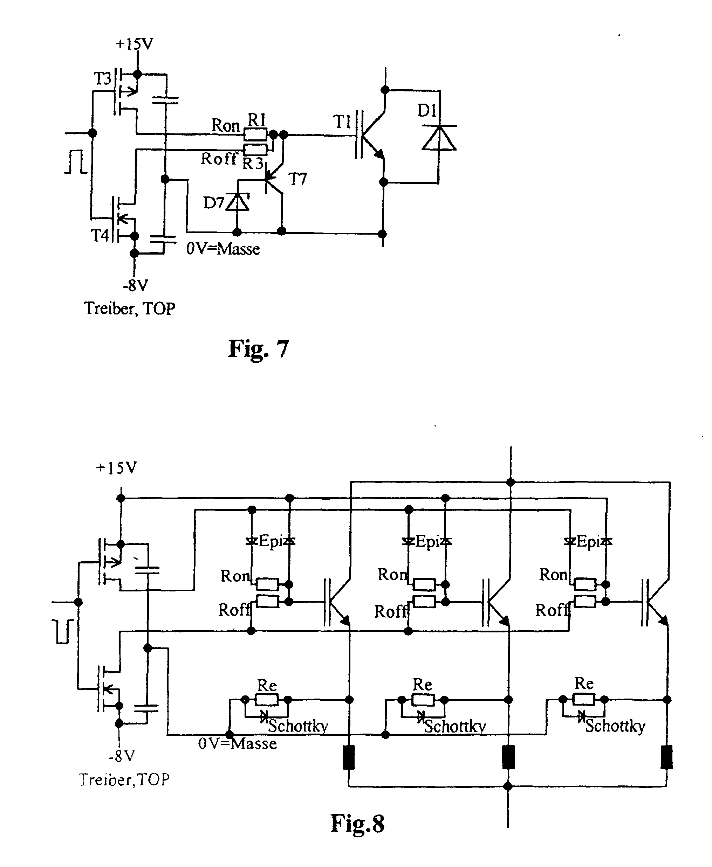

**Fig. 7** stellt eine weitere Variante einer Schaltungsanordnung, wiederum dargestellt als Ausschnitt der TOP- Ansteuerung, mit einer Referenzdiode dar. Durch Einsatz einer temperaturstabilisierten Spannungs- Referenzdiode D₇ in Kombination mit einem pnp-Transistor T₇ ist eine dem Stand der Technik nach Fig. 3 analoge Lösung realisierbar. Nachteilig wirkt sich bei einer solchen Schaltungsvariante jedoch aus, daß die Basis- Ernitter-Strecke des pnp- Transistors T₇ bei abgeschaltetem IGBT T₁ bei ca. 8 V sperren muß. Dieses Problem ist durch Reduzieren der negativen Versorgungsspannung des Treibers von -8 V auf -5 V zu minimieren, was in den meisten praktischen Fällen keine Einschränkung bedeutet.

**Fig. 8** zeigt einen analog zu den vorhergehenden Fig. 2 bis 7 skizzierten Schaltungsausschnitt mit Hilfsemitter- Widerständen und Schottky- Dioden. Diese erfinderische Schaltungsanordnung zeigt eine Problemlösung auf, die bei den gegebenen schaltungsbedingten Toleranzen und Temperaturschwankungen eine einwandfreie und kurzschlußfeste Arbeitsweise garantiert und im Gegensatz zu den Schaltungsvarianten der Fig. 3 bis 5 und 7 ausgezeichnet für den Parallelbetrieb mehrerer IGBT- Schalter geeignet ist. Ausführliche Messungen an parallelgeschalteten Modulen bei unterschiedlichsten Betriebsbedingungen haben gezeigt, daß bei der Ansteuerung sowohl Maßnahmen im Gate- Kreis als auch bei den Hilfsemitter-Anschlüssen erforderlich waren, sie sind in der Fig. 8 zusammengefaßt, die Begründung für die erfinderischen Schaltungsaufbauten im Hilfsemitterkreis wurde bei der Beschreibung zu den Fig. 2a und b gegeben.

Bei ungleichen Stromschleifen, jeweils bezogen auf eine DCB- Keramik (direct cupper bonding) bzw. ein Modul, sind auch die parasitären Induktivitäten pro DCB- Keramik verschieden. Hierdurch treten insbesondere bei Kurzschluß unterschiedlich hohe Ströme auf. Die DCB mit der kleinsten Induktivität hat den höchsten Kurzschlußstrom. Dies wirkt sich auch auf die Emitterspannungen aus. Hierdurch sind die Emitterspannungen unterschiedlich. Ohne die Schottky- Dioden wird die mittlere Emittterspannung als Referenz für den Treiber benutzt. Hierdurch kann eine DCB- Keramik eine zu hohe oder zu niedrige Gatespannung erhalten.

Die Differenzen in den Gatespannungen hängen von den Differenzen in den Emitterspannungen ab und können sehr beachtliche Werte annehmen. Zu hohe Gatespannungen sind aber zu vermeiden, da sehr hohe Gatespannungen zu hohe Kurzschlußströme erlauben. Mit niedrigeren Gatespannungen tritt eine Kurzschlußstrom- Begrenzung bei niedrigeren Werten auf. Die Epitaxial- und Schottky- Dioden in **Fig. 8** bewirken, daß an keinem Modul die Gatespannung über +15 V plus ca. 0,5 bis 1 Volt als Summe der beiden Diodenschwellen ansteigen kann.

Messungen an parallelgeschalteten Module haben gezeigt, daß eine nicht unwesentliche gegenseitige Beeinflussung der Gatepotentiale möglich ist. Es kommt bedingt durch die parasitäre Emitterinduktivitäten, insbesondere bei Ungleichmässigkeiten in der Stromaufteilung, zu Ungleichmässigkeiten in den Emitterspannungen. Diese wirken über die interne Gate- Emitter- Kapazitäten der IGBT auf das Gatepotential zurück. Hierbei kann es insbesondere bei Kurzschlüssen zu unerwünschten Schwingungen zwischen den Gateanschlüssen kommen. Die Widerstände zwischen den Gateanschlüssen müssen so hochohmig wie möglich sein, damit Ausgleichsvorgänge zwischen diesen Anschlüssen so weit wie möglich reduziert bzw. vermieden werden. Durch folgende Maßnahmen wird dies erfindungsgemäß erreicht:
1. Jedes IGBT- Modul wird mit eigenen Gatewiderständen versehen.
2. Die Gatewiderstände Rₒₙ zum Einschalten der IGBT und R_{off} zum Ausschalten der IGBT werden unterschieden. Bei Messungen hat sich als Ergebnis gezeigt, daß die Gatewiderstände R_{off} zum Ausschalten der IGBT wesentlich hochohmiger dimensioniert werden können als die Gatewiderstände Rₒₙ zum Einschalten der IGBT.
3. In Reihe mit den niederohmigen Gatewiderstände Rₒₙ zum Einschalten der IGBT verschaltete Dioden verhindern einen Ausgleich zwischen den Gateanschlüssen über diese Widerstände. Als Dioden im Gate- Kreis sollten wegen ihrer geringen parasitären Kapazitäten vorzugsweise schnelle Epitaxialdioden eingesetzt werden.
4. Es werden zusätzlich Ableitdioden gegen die Versorgungsspannung für jedes Modul vorgesehen, damit aufgrund von IGBT- internen kapazitiven Rückwirkungen keine Gate-Spannungserhöhung höher als die Versorgungsspannung der Treiberstufe auftritt. Eine zu hohe Gatespannung kann im Falle eines Kurzschlusses zu hohen Kurzschlußströmen und damit zur Zerstörung der Schaltungsanordnung führen.
5 In Reihe mit den höherohmigen R_{off}- Widerständen sind keine Entkoppeldioden erforderlich.
6. Während jeder Schaltphase muß immer eine definierte Spannung an den Gatekontakten anliegen.

Hervorragend geeignet ist die Begrenzungsschaltung insbesondere bei Parallelschaltung von mehreren IGBT, wie sie in **Fig. 8** dargestellt ist.

## Patentansprüche

1. Schaltungsanordnung mit Leistungshalbleiterbauelementen als Schalttransistoren, vorzugsweise IGBT, mit für eine Parallelschaltung geeigneter Gateansteuerung, mit getrennten Gatewiderständen für das Einschalten (Rₒₙ) und Ausschalten (R_{off}), und getrennten Hilfsemitterwiderständen (R_{E}) für jeden Leistungsschalter zur Erzielung einer kurzschlußsicheren Arbeitsweise, wobei der Masseanschluß fiir die Treiberschaltung am Summenpunkt der Hilfsemitterwiderstände angeschlossen ist,
**dadurch gekennzeichnet,daß**
in Reihe mit dem Gatewiderstand Rₒₙ eine Diode mit der Kathode zum Gatewiderstand Rₒₙ, parallel zu den Hilfsemitterwidenständen (R_{E}) je eine Clamping- Diode mit Kathode zum Emitter und am jeweiligen Gate eine Ableitdiode mit der Kathode zu der Gateversorgungsspannung geschaltet sind.

2. Schaltungsanordnung nach Anspruch 1, **dadurch gekennzeichnet, daß**
der Gatewiderstand Rₒₙ relativ niederohmig und der Gatewiderstand R_{off} dazu relativ hochohmig dimensioniert sind.

3. Schaltungsanordnung nach Anspruch 1, **dadurch gekennzeichnet, daß**
die Dioden schnelle Epitaxialdioden mit niedrigen differentiellen Innenwiderständen und niedrigen Sperrschichtkapazitäten sind.

4. Schaltungsanordnung nach Anspruch 1, **dadurch gekennzeichnet, daß**
die Clamping- Dioden, die parallel zum Widerstand Rₑ geschaltet sind, Schottky- Dioden sind.

## Claims

1. Power circuit arrangement having power semiconductor elements as switching transistors, preferably IGBT, having a gate drive which is suited for parallel switching, having separated gate resistors for switching on (Rₒₙ) and switching off (R_{off}), and separated auxiliary emitter resistors (R_{E}) for each power switch in order that a short-circuit-proof operation is obtained, the mass connection for the driver circuit being connected at the sum point of the auxiliary emitter resistors,
**characterized in that**
in series with the gate resistor Rₒₙ, a diode with the cathode is switched to the gate resistor Rₒₙ, in parallel to the auxiliary resistors R_{E}, one clamping diode each with a cathode is switched to the emitter, and at the respective gate, a bypass diode with a cathode is switched to the gate supply voltage.

2. Power circuit arrangement according to claim 1, **characterized in that** the gate resistor Rₒₙ is relatively low-ohmic dimensioned and, compared therewith, the gate resistor R_{off} is relatively high-ohmic dimensioned.

3. Power circuit arrangement according to claim 1, **characterized in that** the diodes are fast epitaxial diodes having low differential internal resistors and low barrier layer capacities.

4. Power circuit arrangement according to claim 1, **characterized in that** the clamping diodes, which are switched in parallel to the resistor Rₑ, are Schottky diodes.

## Revendications

1. Système de circuit, comprenant des dispositifs de puissance à semi-conducteur comme des transistors de commutation, de préférence des IGBT, avec une commande de grille adaptée à une connexion en parallèle, avec des résistances de grille séparées pour la mise en circuit (Rₒₙ) et la mise hors circuit (R_{off}), et des résistances d'émetteur auxiliaire (R_{E}) séparées pour chaque disjoncteur afin d'obtenir un mode de fonctionnement résistant aux courts-circuits, la connexion à la masse pour le circuit d'attaque étant connectée au point de sommation des résistances d'émetteur auxiliaire,
**caractérisé en ce qu'**une diode avec la cathode menant à la résistance de grille Rₒₙ est connectée en série avec la résistance de grille Rₒₙ, respectivement une diode de niveau avec une cathode menant à l'émetteur est connectée en parallèle aux résistances d'émetteur auxiliaire (R_{E}), et à la grille respective, une diode de dérivation est connectée avec la cathode menant à la tension d'alimentation de la grille.

2. Système de circuit selon la revendication 1, **caractérisé en ce que** la résistance de grille Rₒₙ est dimensionnée avec une impédance relativement basse, et que par rapport à celle-ci, la résistance de grille R_{off} est dimensionnée avec une impédance relativement élevée.

3. Système de circuit selon la revendication 1, **caractérisé en ce que** les diodes sont des diodes épitaxiales rapides avec des résistances internes différentielles faibles et des capacités de transition faibles.

4. Système de circuit selon la revendication 1, **caractérisé en ce que** les diodes de niveau, qui sont connectées en parallèle à la résistance Rₑ, sont des diodes Schottky.
